(19) **Europäisches Patentamt / European Patent Office / Office européen des brevets**

(11) **EP 1 450 168 B1**

(12) **EUROPÄISCHE PATENTSCHRIFT**

(45) Veröffentlichungstag und Bekanntmachung des Hinweises auf die Patenterteilung:
**01.08.2007  Patentblatt 2007/31**

(51) Int Cl.:
*G01R 17/10* (2006.01)  *G01R 17/16* (2006.01)
*G01R 31/26* (2006.01)  *G01R 19/165* (2006.01)

(21) Anmeldenummer: **04003963.8**

(22) Anmeldetag: **21.02.2004**

(54) **Elektrische Schaltung zum Treiben einer Last**

Electric circuit for driving a load

Circuit électrique pour alimenter une charge

(84) Benannte Vertragsstaaten:
**AT BE BG CH CY CZ DE DK EE ES FI FR GB GR HU IE IT LI LU MC NL PT RO SE SI SK TR**

(30) Priorität: **24.02.2003  EP 03004023**

(43) Veröffentlichungstag der Anmeldung:
**25.08.2004  Patentblatt 2004/35**

(73) Patentinhaber: **ELMOS Semiconductor AG**
**44227 Dortmund (DE)**

(72) Erfinder: **Hartzsch, Jörg**
**44287 Dortmund (DE)**

(74) Vertreter: **Hilleringmann, Jochen et al**
**Patentanwälte**
**Von Kreisler-Selting-Werner,**
**Bahnhofsvorplatz 1 (Deichmannhaus am Dom)**
**50667 Köln (DE)**

(56) Entgegenhaltungen:
EP-A- 0 215 190     EP-A- 0 274 995
DE-C- 943 072       US-A- 1 951 461
US-A- 3 150 315     US-A- 3 227 953
US-A- 4 071 814     US-A- 5 845 275

**Beschreibung**

Die Erfindung betrifft eine elektrische Schaltung zum Treiben einer Last.

Sofern elektrische oder elektromechanische Systeme eine Stromvermessung erfordern, wird diese üblicherweise so durchgeführt, dass der zu messende Strom über einen Shunt-Widerstand geführt wird. Der dabei entstehende Spannungsabfall kann messtechnisch ermittelt und bei bekanntem Widerstandswert in einen Strom umgerechnet werden. Erforderlich ist also die genaue Kenntnis des Widerstandswerts des Shunt-Widerstands. Shunt-Widerstände sind jedoch kostenintensiv und unterliegen relativ hohen Fertigungstoleranzen. Zu dem sind oftmals Montageprobleme zu lösen. Schließlich ist der Widerstandswert eines Shunt-Widerstands temperaturabhängig.

Von daher ist es von Vorteil, wenn man für die Stromvermessung in einem elektrischen oder elektromechanischem System den Spannungsabfall über einnem in diesem Systems vorhandenen Bauelement nutzen kann. Diesbezüglich gilt es aber zu bedenken, dass der Widerstandswert eines derartigen Bauteils innerhalb eines an sich bekannten Widerstandswertbereichs liegen kann. Von daher ist es also erforderlich, den Widerstandswert des Bauelements vor Aufnahme der bestimmungsgemäßen Nutzung des elektrischen oder elektromechanischen Systems zu bestimmen, wobei der einzig bekannte Parameter darin zu sehen ist, dass der mögliche Minimal- und der mögliche Maximalwert für den Widerstand des betreffenden elektrischen Bauelements bekannt ist.

US-A-5,845,275 beschreibt eine Schaltung zur Ermittlung der Strom-Spannungs-Charakteristik eines Halbleiter-Bauelements, bei dem es sich um einen Transistor handeln kann, unter Verwendung einer Fuzzy-Logik-Schaltung zur linearen Approximation. Das Halbleiter-Bauelement wird bestromt und sein Spannungsabfall wird ermittelt.

In US-A-3,150,315 wird eine Messbrücke zur Bestimmung eines Widerstandswertes eines unbekannten Impedanzelements, von dem Toleranzgrenzen bekannt sind, beschrieben.

Eine Aufgabe der Erfindung ist es daher, eine elektrische Schaltung mit einer Vorrichtung zur Bestimmung des Widerstandswerts eines Shunt-Elements dieser Schaltung anzugeben, von dem lediglich der maximal mögliche und der minimal mögliche Widerstandswert bekannt sind und der zur ordnungsgemäßen Funktionsweise der Schaltung benötigt wird.

Zur Lösung dieser Aufgabe wird mit der Erfindung eine elektrische Schaltung mit einem Shunt-Element vorgeschlagen, dessen Widerstandswert zwischen einem bekannten Maximal- und einem bekannten Minimalwert liegt, und zwar mit Hilfe einer Messbrücke, wie in Anspruch 1 angegeben. Die abhängigen Ansprüche betreffen einzelne Ausgestaltungen der Erfindung.

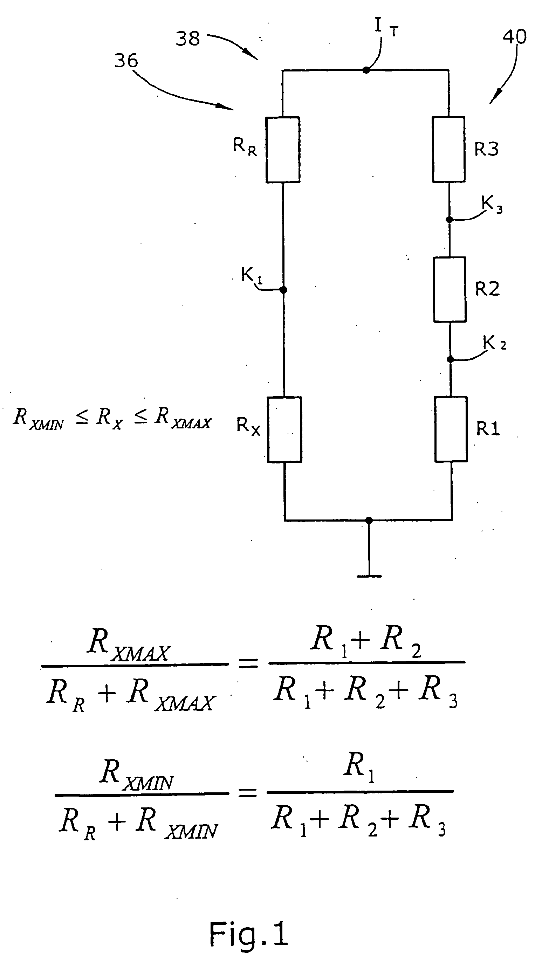

Bei der erfindungsgemäßen Bestimmung des Widerstandswerts des Shunt-Elements wird eine Messbrücke eingesetzt, deren Aufbau ähnlich dem einer Wheatstonschen Messbrücke (siehe z.B. US-A-3 150 315, US-A- 3 227 953, EP-A- 0 215 190 und DE-C-943 072) ist, jedoch mit der Ausnahme, dass keiner der Widerstände veränderbar ist. In dem ersten der beiden Brückenzweige dieser Messbrücke befindet sich neben dem Shunt-Element, dessen Widerstand bestimmt werden soll, ein bekannter Referenzwiderstand. Im zweiten Brückenzweig der Messbrücke befindet sich eine Reihenschaltung von drei bekannten Widerständen. Die Werte der bekannten Widerstände der Messbrücke werden so, wie oben beschrieben, festgelegt. Die erfindungsgemäße Messbrücke ist in Fig. 1 wiedergegeben. Vom zu bestimmenden Widerstand $R_X$ ist lediglich bekannt, dass dieser zwischen $R_{XMIN}$ und $R_{XMAX}$ liegt. Nachdem der Referenzwiderstand $R_R$ des ersten Brückenzweiges und einer der drei Widerstände des zweiten Brückenzweiges, in diesem Fall der Widerstand $R_3$ vorgegeben worden sind, lassen sich die Werte für die Widerstände $R_1$ und $R_2$ aus den nachfolgend genannten beiden Gleichungen errechnen:

$$R_{XMAX} \, / \, (R_R + R_{XMAX}) = (R_1 + R_2) \, / \, (R_1 + R_2 + R_3)$$

$$R_{XMIN} \, / \, (R_R + R_{XMIN}) = R_1 \, / \, (R_1 + R_2 + R_3)$$

Eine derart dimensionierte Messbrücke lässt sich nun beim Einprägen eines Teststroms $I_T$ dazu verwenden, den Widerstandswert von $R_X$, also den Widerstandswerts des Shunt-Elements zu bestimmen. Dazu werden die Differenzspannungen zwischen den Knotenpunkten $K_1$ und $K_2$, $K_1$ und $K_3$ bzw. $K_2$ und $K_3$ messtechnisch ermittelt. Zwei dieser Differenzspannungen müssen ermittelt werden, um daraus den Widerstandswert von $R_X$ ermitteln zu können (zum Beispiel gemäß Dreisatz).

Ist beispielsweise die Spannungsdifferenz zwischen den Knotenpunkten $K_1$ und $K_2$ gleich 0 Volt, so ist der Wert des Widerstandes $R_X$ gleich seinem Minimalwert. Ist dagegen die Differenzspannung zwischen den Knotenpunkten

$K_1$ und $K_3$ gleich 0 Volt, so ist der Wert des Widerstandes $R_X$ gleich dem Maximalwert. Bei Differenzspannungswerten zwischen den Knotenpunkten $K_1$ und $K_2$ bzw. $K_1$ und $K_3$ von ungleich 0 Volt, ist der Wert des Widerstandes $R_X$ gleich dem entsprechenden Prozentualanteil des Maximal- bzw. Minimalwerts.

Auf die oben beschriebene Weise lässt sich also der Wert des Widerstandes $R_X$, das heißt der Widerstandswert des Shunt-Elements der erfindungsgemäßen Schaltung messtechnisch bestimmen, wenn von dem Shunt-Element lediglich bekannt ist, dass sein Widerstandswert zwischen einem bekannten Maximal- und einem bekannten Minimalwert liegt.

Durch die Erfindung ist es möglich, für eine Strommessung innerhalb eines elektrischen oder elektronischen bzw. elektromechanischen Systems als Shunt-Widerstand einen Transistor dieses Systems zu nutzen, von dem lediglich der maximal zulässige Widerstandswertebereich bekannt ist. Bei dem damit verwendbaren Transistor kann es sich dann also beispielsweise um einen Verpolschutztransistor oder auch einen eine Last schaltenden Transistor (Highside- bzw. Lowside-Schalter) handeln, von dem der Minimal- und der Maximalwert des EIN-Widerstandes bekannt ist. Aber auch jeder andere einen ohmschen Anteil aufweisende Transistor, das heißt auch ein Widerstand, ist als zu vermessendes Shunt-Element verwendbar.

Im Regelfall ist der erfindungsgemäß als Ersatz für einen Shunt-Widerstand verwendbare Transistor, wie beispielsweise ein Verpolschutztransistor oder ein eine Last schaltender Transistor, temperaturabhängig, was seinen EIN-Widerstand angeht. Es ist daher zweckmäßig, die zuvor beschriebene erfindungsgemäße Kalibrierung dann durchzuführen, wenn sich die Temperatur des als Shunt-Widerstand verwendeten Transistors verändert. Die Temperaturermittlung kann messtechnisch durch einen Temperatursensor erfolgen. Alternativ ist es aber auch möglich, anhand der elektrischen Belastungen, insbesondere anhand des den Transistor durchfließenden Stromes, auf die thermische Belastung und damit auf die Erwärmung des Transistors rückzuschließen. Eine weitere Möglichkeit der Widerstandsbestimmung des temperaturabhängigen Transistors besteht darin, dass Kalibrierverfahren zyklisch nach Ablauf jeweils einer Zeitspanne durchzuführen, d.h. den zu bestimmenden Widerstandswert jeweils aktuell zu bestimmen.

Die Erfindung wird nachfolgend anhand der Zeichnung näher erläutert. Im Einzelnen zeigen:

Fig. 1        die nach der Erfindung vorgesehene Widerstands-Messbrücke und

Fig.2 bis 4      unterschiedliche Varianten einer erfindungsgemäßen Schaltung zur Vermessung der Ohmschen Widerstände von Transistoren der Schaltung bzw. eines Widerstandes der Schaltung, die während der Applikation der Strommessung dienen.

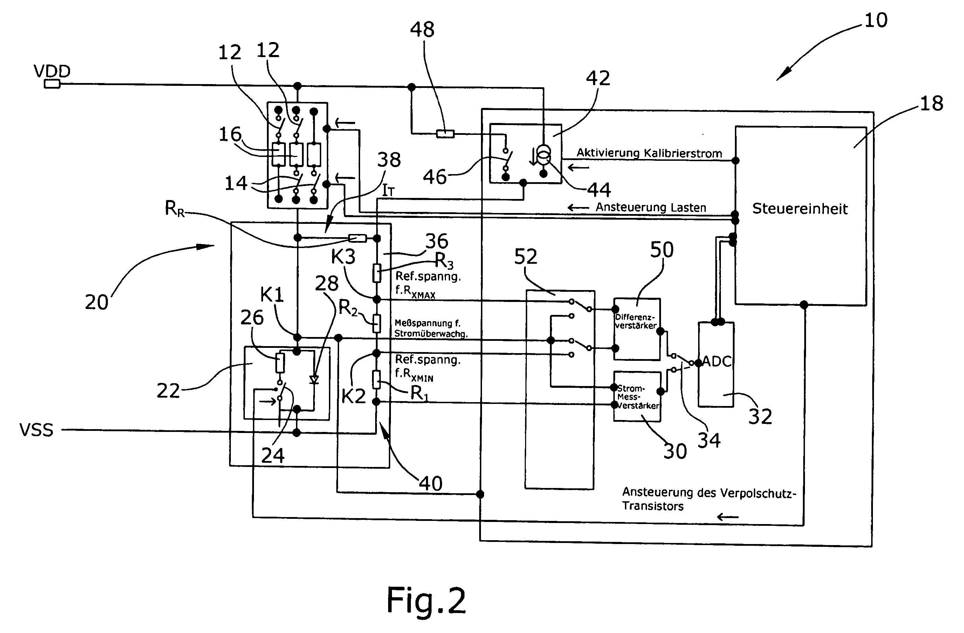

Ein erstes Ausführungsbeispiel eines elektrischen bzw. elektromechanischen Systems 10, bei dem für die Strommessung im Betrieb ein Transistor des Systems 10, in diesem Fall ein Verpolschutztransistor verwendet wird, der zuvor erfindungsgemäß vermessen worden ist, ist in Fig. 2 dargestellt. Das System 10 umfasst eine elektrische Schaltung, mit der in diesem Ausführungsbeispiel Highside- und Lowside-Schalter 12, 14 angesteuert werden, die ihrerseits eine Last 16 treiben. Die Highside- und Lowside-Schalter 12, 14 werden über eine Steuereinheit 18 angesteuert. Im Energieversorgungspfad des Laststromkreises 20 befindet sich ein Verpolschutztransistor 22, von dem in Fig. 2 das Ersatzschaltbild bestehend aus einem Schalter 24, einem EIN-Widerstand 26 und einer zu beiden parallel geschalteten Diode 28 dargestellt ist. Auch der Verpolschutztransistor 22 wird über die Steuereinheit 18 angesteuert.

Erfindungsgemäß wird nun dieser Verpolschutztransistor 22 bzw. genauer gesagt sein EIN-Widerstand 26 (nachfolgend auch mit $R_X$ bezeichnet) für die Strommessung verwendet. Dazu wird von einem Strommessverstärker 30 der Spannungsabfall über dem EIN-Widerstand $R_X$ erfasst und mittels eines mit dem Ausgang des Verstärkers 30 verbundenen A/D-Wandlers 32 der Steuereinheit 18 zugeführt. Bei bekanntem Wert für den EIN-Widerstand $R_X$ kann dann anhand des gemessenen Spannungsabfalls der Strom errechnet werden. Während der Applikation verbindet also der Schalter 34 zwischen dem Strommessverstärker 30 und dem A/D-Wandler 32 beide Einheiten (siehe gestrichelte Linie in Fig. 2).

Der Schaltzustand des Schalters 34 wird ebenfalls über die Steuereinheit gesteuert, was in Fig.2 jedoch nicht dargestellt ist. Um nun den EIN-Widerstand $R_X$, dessen Minimalwert und dessen Maximalwert bekannt sind, dessen exakter Wert jedoch unbekannt ist, vermessen zu können, ist die zuvor beschriebene Schaltung des Systems 10 um die nachfolgend aufgeführten Bauteile und Schaltungskomponenten ergänzt. Hier ist zunächst einmal die Einbindung des Verpolschutztransistors 22 in eine abgewandelte Widerstandsmessbrücke 36 zu nennen. Dabei ist in Reihe mit dem EIN-Widerstand $R_X$ ein Referenzwiderstand $R_R$ geschaltet. Parallel zu dieser Reihenschaltung aus Referenzwiderstand $R_R$ und Verpolschutztransistors 22 geschaltet ist eine weitere Widerstandsreihenschaltung, die die drei Widerstände $R_1$, $R_2$ und $R_3$ umfasst. Der erste Brückenzweig der Messbrücke 36 umfasst also den Referenzwiderstand $R_R$ und den Verpolschutztransistor 22, während der zweite Brückenzweig 40 die drei Widerstände $R_1$, $R_2$ und $R_3$ umfasst. Zwischen den einzelnen Widerständen ergeben sich dann die Knoten- bzw. Widerstandsverbindungspunkte $K_1$, $K_2$ und $K_3$.

Zur Einprägung eines Mess- bzw. Kalibrierstroms in die Messbrücke 36 dient die Einheit 42, die entweder als Stromquelle 44 ausgebildet ist oder einen Schalter 46 aufweist, bei dessen Schließen über einen Widerstand 48 Strom in die Messbrücke 36 eingeprägt wird. Die Aktivierung des Kalibrierstroms erfolgt durch die Steuereinheit 18.

Darüber hinaus bedarf es für die Vermessung des EIN-Widerstandes $R_X$ noch eines Differenzverstärkers 50, der über einen vorgeschalteten Multiplexer 52 wahlweise die Differenzspannungen zwischen den Widerstandsverbindungspunkten $K_1$ und $K_2$, $K_1$ und $K_3$ bzw. $K_2$ und $K_3$ ermittelt. Das Ausgangssignal des Differenzverstärkers 50 wird der Steuereinheit 18 über den A/D-Wandler 32 zugeführt. Hierfür nimmt der Schalter 34 seine in Figur 2 in durchgezogener Linie dargestellte Schaltposition an.

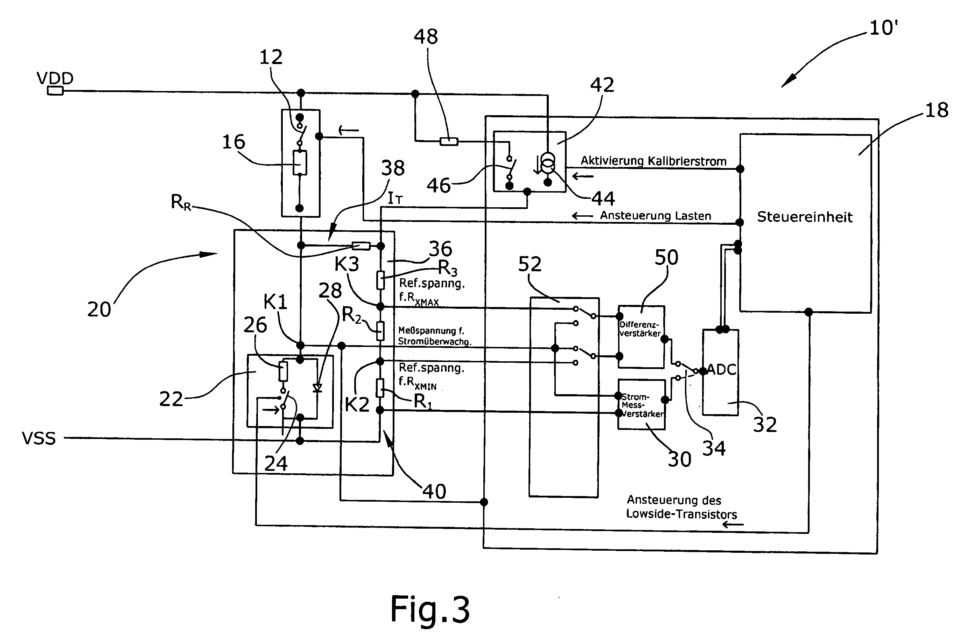

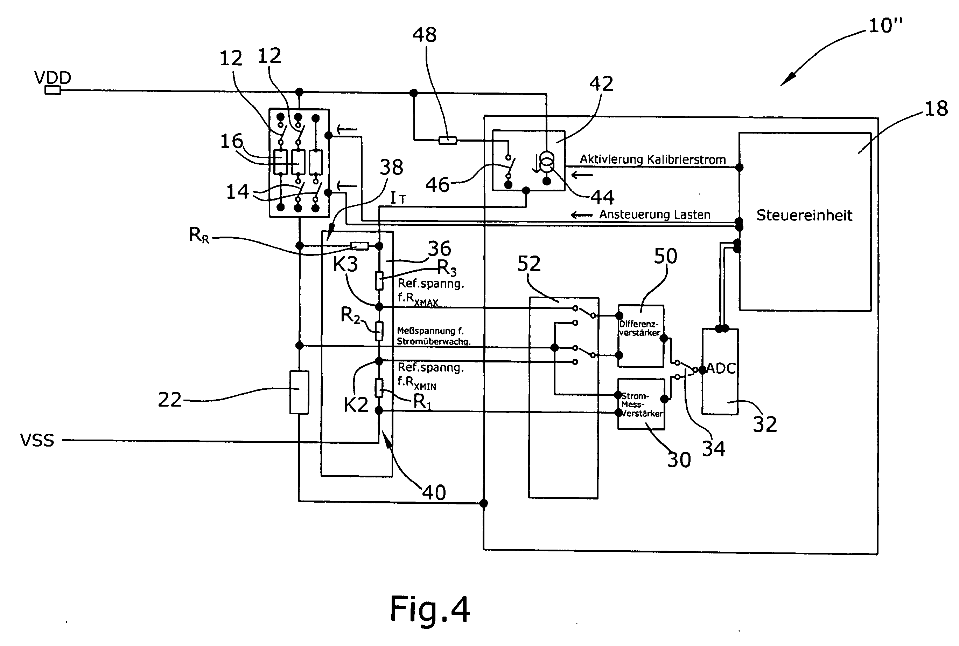

Die Fign. 3 und 4 zeigen zwei zum System 10 gemäß Fig. 2 alternative Konzepte, bei denen gemäß Fig. 3 ein Lowside-Schalter als Shunt-Widerstand für die Strommessung und in Fig. 4 ein Ohmscher Widerstand als Shunt-Widerstand verwendet wird. Der grundsätzliche Aufbau dieser beiden Alternativsysteme 10' und 10" ist jedoch der gleiche wie anhand von Fig. 2 beschrieben.

Für sämtliche Varianten gilt bezüglich der Dimensionierung der noch festzulegenden Widerstände $R_1$, $R_2$, $R_3$ und $R_R$ der Widerstandsmessbrücke 36 unter Bezugnahme auf das im Zusammenhang mit der Beschreibung von Fig. 1 gesagte Folgendes.

Die einzigen festliegenden Größen der Widerstandsmessbrücke 36 sind der Maximal- und der Minimalwert $R_{XMAX}$ und $R_{XMIN}$ des Widerstandes $R_X$.

Zunächst werden nun der Widerstandswert für den Widerstand $R_R$ sowie der Kalibrierstrom festgelegt. Beide Parameter sind so zu wählen, dass sich die während der Kalibration ergebende Spannung am Widerstandsverbindungspunkt $K_3$ am oberen Rand des durch den Differenzverstärker 50 verarbeitbaren Spannungsbereich befindet.

Danach wird die Summe der Widerstände $(R_1 + R_2 + R_3)$ festgelegt. Diese Summe kann durchaus recht hochohmig sein, wobei wichtig ist, dass Eingangsströme des Strommessverstärkers 30 vernachlässigbar bleiben.

Die Berechnung der Werte für die Widerstände $R_1$ und $R_2$ erfolgt dann durch Auflösung der zuvor genannten Gleichungen, wobei gilt:

$$R_1 = R_{XMIN} \times (R_1 + R_2 + R_3) / (R_R + R_{XMIN})$$

$$R_2 = R_{XMAX} \times (R_1 + R_2 + R_3) / (R_R + R_{XMAX}) - R_1$$

$$R_3 = (R_1 + R_2 + R_3) - R_1 - R_2$$

Nachdem auf die zuvor beschriebene Weise die Dimensionierung der Widerstände der Messbrücke 36 erfolgt ist, wird nun die Vermessung des Widerstandes $R_X$ durchgeführt.

Hierzu wird ein Kalibrierstrom $I_T$ in die Widerstandsmessbrücke 36 eingeprägt. Dies erfolgt alternativ entweder durch Schließen des Schalters 46, wodurch über den Referenzwiderstand $R_R$ und den Verpolschutztransistor 22 (Fig. 2) ein definierter Kalibrierstrom fließt. Alternativ kann der Kalibrierstrom auch mittels einer Stromquelle 44 der Einheit 42 erzeugt werden. Ein vernachlässigbar geringer Anteil des Kalibrierstroms wird über den zweiten Brückenzweig 40 der Messbrücke 36 geführt. Dieser zweite Brückenzweig 40 generiert die Minimal- und Maximalreferenzen des zu vermessenden Widerstandes $R_X$, wie oben erläutert ist.

Über den Differenzverstärker 50 mit schaltbarem Eingangs-Multiplexer 52 können nun folgende vier Messungen durchgeführt werden:

a)

$$\Delta U(K_1 - K_2)$$

b)

$$\Delta U(K_3 - K_1)$$

c)

$$\Delta U(K_3 - K_2)$$

d)

$$\Delta U(K_1 - K_1) \text{ zum Offset-Abgleich}$$

Varianten d.1) Offsets können direkt mit der Messtechnik ermittelt werden, sofern der Differenzverstärker 50 und der A/D-Wandler 32 negative wie positive Spannungsdifferenzen verarbeiten können
d.2) Der Differenzverstärker 50 erhält designseitig einen typisch positiven Offset (damit ist dieser immer messbar, auch bei nur unipolar arbeitendem A/D-Wandler 32)

Zur Minimierung von Fehlern durch Nichtlinearitäten des Differenzverstärkers 50 und des A/D-Wandlers 32 (insbesondere im Bereich kleiner Eingangsspannungen) sollten zweckmäßigerweise folgende Verfahren angewendet werden:

1. Es werden alle vier möglichen Messungen 3)a bis 3d) durchgeführt.
2. Von allen vier Messwerten wird der Offset $\Delta U(K_1 - K_1)$ subtrahiert.
3. Es wird ermittelt, welcher der beiden Messwerte a) oder b) der größere ist.
4. Mit diesem größeren Wert wird per Dreisatz ermittelt, bei wieviel Prozent zwischen unterer Referenz ($K_2$) und oberer Referenz ($K_3$) die Spannung an $K_1$ gemessen wurde.

4.a)

$$\text{Wenn } \Delta U(K_3 - K_1) > \Delta U(K_1 - K_2)$$
$$\# \Delta U \% = 100 \times \Delta U(K_3 - K_2) - \Delta U(K_3 - K_1) / \Delta U(K_3 - K_2)$$

4.b)

$$\text{Wenn } \Delta U(K_3 - K_1) < \Delta U(K_1 - K_2)$$
$$\# \Delta U \% = 100 \times \Delta U(K_1 - K_2) / \Delta U(K_3 - K_2)$$

Die absoluten Spannungen, bezogen auf VSS-Potential, sind hierbei unwichtig. Daher ist weder ein exakter Kalibrierstrom noch ein exakter Verstärkungsfaktor notwendig. Beide Parameter müssen nur über die drei Messungen hinweg konstant bleiben.
5. Aus der prozentualen Angabe $\Delta U \%$ lässt sich nun ebenfalls per Dreisatz der zu bestimmende Widerstand $R_X$ errechnen. Im Spannungsteiler entspricht das Verhältnis der Widerstandswerte dem Verhältnis der an den Widerständen abfallenden Spannungen. Es gilt also:

$$R_X = R_{XMIN} + \Delta U \% \times (R_{XMAX} - R_{XMIN}) / 100$$

Die Werte $R_{XMAX}$ und $R_{XMIN}$ sind dem System bekannt. Sie stellen das obere Ende und untere Ende des messbaren Widerstandsbereichs dar und werden vom Entwickler festgelegt.

Der Steuereinheit 18 ist nun der Widerstandswert $R_X$ der als Shunt genutzten Struktur bekannt.

Fließt nun in der laufenden Applikation ein Strom durch diesen Shunt $R_X$, so wird der Spannungsabfall über den Strommessverstärker 30 an den A/D-Wandler 32 und die Steuereinheit 18 übertragen. Diese kann nun aus dem Spannungsabfall und dem bekannten Widerstandswert $R_X$ die Stromaufnahme der Applikation errechnen.

**Patentansprüche**

1. Elektrische Schaltung zum Treiben einer Last, mit

   - Schaltern (12,14) zum Treiben der Last,
   - einem von einem Laststrom durchflossenen Shunt-Element (22) mit ohmschem Anteil,
   - einer Messeinrichtung (30,32) zur Bestimmung des Spannungsabfalls über diesem Shunt-Element (22) im vom Laststrom durchflossenen Zustand,
   - einer Vorrichtung zur Bestimmung des Widerstandswerts des Shunt-Elements (22) wobei dieser Widerstandswert zwischen einem bekannten Maximalwert ($R_{XMAX}$) und einem bekannten Minimalwert ($R_{XMIN}$) liegt und die Vorrichtung zur Bestimmung des Widerstandswerts versehen ist mit

     - einer Messbrücke (36), in deren ersten Brückenzweig (38) das Shunt-Element (22) und ein bekannter Referenzwiderstand ($R_R$) geschaltet sind und in deren zweiten Brückenzweig (40) drei jeweils bekannte Widerstände ($R_1$, $R_2$, $R_3$) geschaltet sind,
     - wobei der erste Brückenzweig (38) einen Widerstandsverbindungspunkt ($K_1$) zwischen dem Referenzwiderstand ($R_R$) und dem Shunt-Element (22) aufweist und der zweite Brückenzweig (40) einen ersten Widerstandsverbindungspunkt ($K_2$) zwischen dem mit dem Shunt-Element (22) verbundenen ersten Widerstand ($R_1$) und dem zweiten Widerstand ($R_2$) sowie einen zweiten Widerstandsverbindungspunkt ($K_3$) zwischen dem zweiten Widerstand ($R_2$) und dem mit dem Referenzwiderstand verbundenen dritten Widerstand ($R_3$) aufweist und
     - wobei die Werte des Referenzwiderstandes ($R_R$) des ersten Brückenzweiges (38) und der drei Widerstände ($R_1$, $R_2$, $R_3$) des zweiten Brückenzweiges (40) derart gewählt sind, dass (i) das Potential des Widerstandsverbindungspunkts ($K_1$) des ersten Brückenzweiges (38) gleich dem Potential des ersten Widerstandsverbindungspunktes ($K_2$) des zweiten Brückenzweiges (40) ist, wenn das Shunt-Element (22) seinen Minimalwiderstandswert ($R_{XMIN}$) aufweist, und (ii) das Potential des Widerstandsverbindungspunkts ($K_1$) des ersten Brückenzweiges (38) gleich dem Potential des zweiten Widerstandsverbindungspunkts ($K_3$) des zweiten Brückenzweiges (40) ist, wenn das Shunt-Element (22) seinen Maximalwiderstandswert ($R_{XMAX}$) aufweist,
     - einer Vorrichtung (42) zum Einprägen eines Messstroms in die Messbrücke (36) und damit in das Shunt-Element (22),
     - einer Einrichtung (32,50,52) zur Vermessung der Differenzspannungen zwischen den Widerstandsverbindungspunkten ($K_1$,$K_2$,$K_3$), und
     - einer Steuereinheit (18) zum Steuern der Vorrichtung (42) zur Einprägung des Messstromes in das Shunt-Element (22), zur Steuerung der Schalter (12,14), zur Steuerung der Messeinrichtung (30), zur Steuerung der Einrichtung (32,50,52) zur Vermessung der Differenzspannungen, zur Berechnung des Widerstandes aus den gemessenen Differenzspannungen und zur Berechnung des Laststromes aus dem Spannungsabfall über dem Shunt-Element (22) und dem berechneten Widerstand.

2. Elektrische Schaltung nach Anspruch 1, **dadurch gekennzeichnet, dass** das Shunt-Element ein Transistor (22) ist und dass die Steuereinheit (18) zur Ansteuerung des Transistors (22) vorgesehen ist.

3. Elektrische Schaltung nach Anspruch 2, **dadurch gekennzeichnet, dass** der Transistor (22) ein Verpolschutztransistor oder ein die Last (16) schaltender Transistor ist.

4. Elektrische Schaltung nach Anspruch 1, **dadurch gekennzeichnet, dass** das Shunt-Element ein ohmscher Widerstand ist.

5. Elektrische Schaltung nach einem der Ansprüche 1 bis 4, **gekennzeichnet durch** einen Multiplexer (52) zum wahlweisen Weiterleiten einer der Messspannungen an eine Spannungsmesseinrichtung (50).

**6.** Elektrische Schaltung nach einem der Ansprüche 1 bis 5, **gekennzeichnet durch** eine Einrichtung zum Vermessen von Einzelspannungen zwischen jeweils den Widerstandsverbindungspunkten ($K_1$, $K_2$, $K_3$) und einem gemeinsamen Bezugspotential und zur Subtraktion von jeweils zwei gemessenen Einzelspannungen.

**7.** Elektrische Schaltung nach einem der Ansprüche 1 bis 6, **gekennzeichnet durch** einen A/D-Wandler (32) zur Messung der Spannungen.

**8.** Elektrische Schaltung nach Anspruch 7, **gekennzeichnet durch** einen Umschalter (34) am Eingang des A/D-Wandlers (32) zur Nutzung des A/D-Wandlers (32) einerseits für Spannungsmessungen und andererseits für Messungen des Spannungsabfalls über dem Transistor (22), dessen Widerstandswert ($R_X$) zur Ermittlung des Laststroms zu bestimmen ist.

**9.** Elektrische Schaltung nach Anspruch 2 oder einem der Ansprüche 3 bis 8, sofern auf Anspruch 2 oder 3 rückbezogen, **gekennzeichnet durch** einen Temperatursensor zur Erfassung der Umgebungstemperatur des Transistors (22), dessen Widerstandswert ($R_X$) zu bestimmen ist.

## Claims

**1.** An electrical circuit for driving a load, comprising

- switches (12,14) for driving the load,
- a shunt element (22) with ohmic portion, having a load current flowing therethrough,
- a measurement device (30,32) for determining the voltage drop across this shunt element (22) in the condition of having the load current flowing therethrough,
- a device for determining the resistance value of the shunt element (22), this resistance value being between a known maximum value ($R_{XMAX}$) and a known minimum value ($R_{XMIN}$) and the device for determining the resistance value is provided with

    - a measuring bridge (36) having the shunt element (22) and a known reference resistor ($R_R$) arranged in its first bridge arm (38) and having three respectively known resistors ($R_1,R_2,R_3$) arranged in its second bridge arm (40),
    - the first bridge arm (38) comprising a resistor connecting point ($K_1$) between the reference resistor ($R_R$) and the shunt element (22), and the second bridge leg (40) comprising a first resistor connecting point ($K_2$) between the first resistor ($R_1$) connected to the shunt element (22), and the second resistor ($R_2$), as well as a second resistor connecting point ($K_3$) between the second resistor ($R_2$) and the third resistor ($R_3$) connected to the reference resistor, and
    - the values of the reference resistor ($R_R$) of first bridge arm (38) and of the three resistors ($R_1,R_2,R_3$) of the second bridge arm (40) being selected in such a manner that (i) the potential of the resistor connecting point ($K_1$) of the first bridge leg (38) is equal to the potential of the first resistor connecting point ($K_2$) of the second bridge leg (40) if the shunt element (22) is at its minimum resistance value ($R_{XMIN}$), and (ii) the potential of the resistor connecting point ($K_1$) of the first bridge leg (38) is equal to the potential of the second resistor connecting point ($K_3$) of the second bridge leg (40) if the shunt element (22) is at its maximum resistance value ($R_{XMAX}$),
    - a device (42) for impressing a measuring current into the measuring bridge (36) and thus into the shunt element (22),
    - a device (32,50,52) for measuring the difference voltages between the resistor connecting points ($K_1,K_2,K_3$), and
    - a control unit (18) provided to control said device (42) for impressing the measuring current into the shunt element (22), to control said switches (12,14), to control said measurement device (30), to control said device (32,50,52) for measuring the difference voltages, to calculate the resistance from the measured voltage differences and to calculate the load current from the voltage drop across the shunt element (22) and the calculated resistance.

**2.** The electrical circuit according to claim 1, **characterized in that** the shunt element is a transistor (22) and that the control unit (18) is provided for driving the transistor (22).

**3.** The electrical circuit according to claim 2, **characterized in that** the transistor (22) is a polarity protection transistor or a transistor switching the load (16).

4. The electrical circuit according to claim 1, **characterized in that** the shunt element is an ohmic resistor.

5. The electrical circuit according to any one of claims 1 to 4, **characterized by** a multiplexer (52) for selectively passing on one of the measurement voltages to a voltage measuring device (50).

6. The electrical circuit according to any one of claims 1 to 5, **characterized by** a device for measuring individual voltages between respectively the resistor connecting points ($K_1$,$K_2$,$K_3$) and a common reference potential, and for subtraction of respectively two measured individual voltages.

7. The electrical circuit according to any one of claims 1 to 6, **characterized by** an A/D converter (32) for measurement of the voltages.

8. The electrical circuit according to claim 7, **characterized by** a switch (34) at the input of the A/D converter (32), for using the A/D converter (32) on the one hand for voltage measurements and on the other hand for measurements of the voltage drop across the transistor (22) of which the resistance value ($R_X$) has to be determined for thus obtaining the load current.

9. The electrical circuit according to claim 2 or any one of claims 3 to 8 as far as related to claim 2 or 3, **characterized by** a temperature sensor for detecting the ambient temperature of the transistor (22) of which the resistance value ($R_x$) has to be determined.

**Revendications**

1. Circuit électrique pour alimenter une charge, comportant

   - des commutateurs (12, 14) pour alimenter la charge,
   - un élément shunt (22) traversé par un courant de charge, avec une partie ohmique,
   - un dispositif de mesure (30, 32) pour déterminer la chute de tension par l'intermédiaire de cet élément shunt (22) dans son état traversé par le courant de charge,
   - un dispositif pour déterminer la valeur de résistance de l'élément shunt (22), cette valeur de résistance étant située entre une valeur maximale connue ($R_{XMAX}$) et une valeur minimale connue ($R_{XMIN}$) et le dispositif pour déterminer la valeur de résistance étant équipé
   - d'un pont de mesure (36), dans la première branche (38) duquel l'élément shunt (22) et une résistance de référence ($R_R$) connue sont montés, et dans la deuxième branche (40) duquel trois résistances ($R_1$, $R_2$, $R_3$) respectivement connues sont montées,
   - la première branche du pont (38) présentant un point de connexion de résistance ($K_1$) entre la résistance de référence ($R_R$) et l'élément shunt (22) et la deuxième branche de pont (40) présentant un premier point de connexion de résistance ($K_2$) entre la première résistance ($R_1$) reliée à l'élément shunt (22) et la deuxième résistance ($R_2$) ainsi qu'un deuxième point de connexion de résistance ($K_3$) entre la deuxième résistance ($R_2$) et la troisième résistance ($R_3$) reliée à la résistance de référence, et
   - les valeurs de la résistance de référence ($R_R$) de la première branche de pont (38) et des trois résistances ($R_1$, $R_2$, $R_3$) de la deuxième branche de pont (40) étant sélectionnées de telle sorte que (i) le potentiel du point de connexion de résistance ($K_1$) de la première branche de pont (38) est égal au potentiel du premier point de connexion de résistance ($K_2$) de la deuxième branche de pont (40) quand l'élément shunt (22) présente sa valeur de résistance minimale ($R_{XMIN}$), et que (ii) le potentiel du point de connexion de résistance ($K_1$) de la première branche de pont (38) est égal au potentiel du deuxième point de connexion de résistance ($K_3$) de la deuxième branche de pont (40) quand l'élément shunt (22) présente sa valeur de résistance maximale ($R_{XMAX}$),
   - d'un dispositif (42) pour l'application d'un courant de mesure dans le pont de mesure (36) et ainsi, dans l'élément shunt (22),
   - d'un dispositif (32, 50, 52) de mesure des tensions différentielles entre les points de connexion de résistance ($K_1$, $K_2$, $K_3$), et
   - d'une unité de commande (18) prévue pour la commande du dispositif (42) d'application du courant de mesure dans l'élément shunt (22), pour la commande des commutateurs (12, 14), pour la commande du dispositif de mesure (30), pour la commande du dispositif (32, 50, 52) de mesure des tensions différentielles, pour le calcul de la résistance à partir des tensions différentielles mesurées et pour le calcul du courant de charge à partir de la chute de tension par l'intermédiaire de l'élément shunt (22) et de la résistance calculée.

2. Circuit électrique selon la revendication 1, **caractérisé en ce que** l'élément shunt est un transistor (22) et **en ce que** l'unité de commande (18) est prévue pour la commande du transistor (22).

3. Circuit électrique selon la revendication 2, **caractérisé en ce que** le transistor (22) est un transistor de polarisation ou un transistor commutant la charge (16).

4. Circuit électrique selon la revendication 1, **caractérisé en ce que** l'élément shunt est une résistance ohmique.

5. Circuit électrique selon l'une des revendications 1 à 4, **caractérisé par** un multiplexeur (52) pour la transmission sélective de l'une des tensions de mesure à un dispositif de mesure de la tension (50).

6. Circuit électrique selon l'une des revendications 1 à 5, **caractérisé par** un dispositif de mesure des tensions individuelles entre respectivement les points de connexion de résistance ($K_1$, $K_2$, $K_3$) et un potentiel de référence commun, et de soustraction de respectivement deux tensions individuelles mesurées.

7. Circuit électrique selon l'une des revendications 1 à 6, **caractérisé par** un convertisseur A/N (32) pour la mesure des tensions.

8. Circuit électrique selon la revendication 7, **caractérisé par** un commutateur (34) à l'entrée du convertisseur A/N (32) en vue de l'utilisation du convertisseur A/N (32) d'une part pour les mesures de tension et d'autre part pour les mesures de chute de tension par l'intermédiaire du transistor (22) dont la valeur de résistance ($R_X$) doit être déterminée pour le calcul du courant de charge.

9. Circuit électrique selon la revendication 2 ou l'une de revendications 3 à 8 pour autant qu'elles se réfèrent à la revendication 2 ou 3, **caractérisé par** un capteur de température pour enregistrer la température ambiante du transistor (22) dont la valeur de résistance ($R_X$) doit être déterminée.

$$R_{XMIN} \le R_X \le R_{XMAX}$$

$$\frac{R_{XMAX}}{R_R + R_{XMAX}} = \frac{R_1 + R_2}{R_1 + R_2 + R_3}$$

$$\frac{R_{XMIN}}{R_R + R_{XMIN}} = \frac{R_1}{R_1 + R_2 + R_3}$$

Fig.1

Fig.2

Fig.3

EP 1 450 168 B1

Fig.4

VDD

10''

48

12 12

42

16

14

38

$I_T$

46

44

Aktivierung Kalibrierstrom

Ansteuerung Lasten

Steuereinheit

18

$R_R$

36

$R_3$

Ref.spanng.
f.$R_{XMAX}$

K3

52

50

Differenzverstärker

$R_2$

Meßspannung f.
Stromüberwachg.

22

Ref.spanng.
f.$R_{XMIN}$

K2

$R_1$

Strom-
Mess-
Verstärker

ADC

34

32

30

VSS

40

EP 1 450 168 B1

13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5845275 A
- US 3150315 A
- US 3227953 A
- EP 0215190 A
- DE 943072 C